Europäisches Patentamt

European Patent Office

Office européen des brevets

(19)

(11) **EP 1 605 562 A2**

(12) **EUROPÄISCHE PATENTANMELDUNG**

(43) Veröffentlichungstag:
**14.12.2005 Patentblatt 2005/50**

(51) Int Cl.7: **H01S 5/026**, H01S 5/183,
H01S 5/04

(21) Anmeldenummer: **05006600.0**

(22) Anmeldetag: **24.03.2005**

(84) Benannte Vertragsstaaten:
**AT BE BG CH CY CZ DE DK EE ES FI FR GB GR
HU IE IS IT LI LT LU MC NL PL PT RO SE SI SK TR**
Benannte Erstreckungsstaaten:
**AL BA HR LV MK YU**

(30) Priorität: **30.07.2004 DE 102004036963
28.05.2004 DE 102004026115**

(71) Anmelder: **Osram Opto Semiconductors GmbH
93049 Regensburg (DE)**

(72) Erfinder:
• **Albrecht, Tony
93077 Bad Abbach (DE)**
• **Brick, Peter
93049 Regensburg (DE)**

(74) Vertreter: **Epping - Hermann - Fischer
Patentanwaltsgesellschaft mbH,
Ridlerstrasse 55
80339 München (DE)**

(54) **Optisch gepumpte oberflächenemittierende Halbleiterlaser-Vorrichtung**

(57) Die Erfindung betrifft eine Oberflächenemittierende Halbleiter-Laservorrichtung, mit mindestens einer monolithisch integrierten Pumpstrahlquelle (20), bei
der die Pumpstrahlquelle (20) wenigstens eine kantenemittierende Halbleiterstruktur (9) aufweist, die zur
Emission elektromagnetischer Strahlung geeignet ist,
deren Intensitätsprofil quer zur Emissionsrichtung (z)
der Halbleiterstruktur einer vorgebaren Kurve folgt.

Die oberflächenemittierende Halbleiterlaser-Vorrichtung emittiert dabei elektromagnetische Strahlung
besonders guter Strahlqualität.

FIG 4

EP 1 605 562 A2

**Beschreibung**

Die Erfindung betrifft eine optisch gepumpte oberflächenemittierende Halbleiterlaser-Vorrichtung.

Die Druckschrift DE 100 267 34 A1 beschreibt eine optisch gepumpte oberflächenemittierende Halbleiterlaser-Vorrichtung mit mindestens einer strahlungserzeugenden Quantentopfstruktur und mindestens einer Pumpstrahlquelle. Dabei dient die Pumpstrahlquelle zum optischen Pumpen der Quantentopfstruktur. Die Pumpstrahlquelle weist eine kantenemittierende Halbleiter-Struktur auf. Die strahlungserzeugende Quantentopfstruktur und die kantenemittierende Halbleiter-Struktur sind auf einem gemeinsamen Substrat epitaktisch aufgewachsen.

Die Druckschrift US 5,991,318 beschreibt einen optisch gepumpten Vertikalresonator-Halbleiterlaser mit einer monolithischen oberflächenemittierenden Halbleiterschichtstruktur. Bei dieser bekannten Vorrichtung wird die optische Pumpstrahlung, deren Wellenlänger kleiner ist als die der erzeugten Laserstrahlung, von einer kantenemittierenden Halbleiterdiode geliefert. Die kantenemittierende Halbleiterlaserdiode ist extern derart angeordnet, dass die Pumpstrahlung schräg von vorne in den Verstärkungsbereich der oberflächenemittierenden Halbleiterschichtstruktur eingestrahlt wird.

Es ist Aufgabe der vorliegenden Erfindung, eine optisch gepumpte oberflächenemittierende Halbleiterlaser-Vorrichtung anzugeben, die elektromagnetische Strahlung besonders guter Strahlqualität emittiert.

Diese Aufgabe wird gelöst durch eine Halbleiterlaser-Vorrichtung nach Patentanspruch 1. Vorteilhafte Ausgestaltungen sind Gegenstand von Unteransprüchen.

Es wird eine oberflächenemittierende Halbleiterlaser-Struktur angegeben. Bevorzugt enthält die Halbleiterlaser-Struktur wenigstens eine zur Erzeugung von elektromagnetischer Strahlung geeignete Struktur. Besonders bevorzugt ist diese oberflächenemittierende strahlungserzeugende Struktur eine Quantentopfstruktur. Die strahlungserzeugende Struktur wird bevorzugt von wenigstens einer Pumpstrahlquelle optisch gepumpt. Besonders bevorzugt handelt es sich bei der Pumpstrahlquelle um eine kantenemittierende Halbleiter-Struktur. Beispielsweise kann es sich bei der Pumpstrahlquelle um einen kantenemittierenden Breitstreifenlaser handeln.

Pumpstrahlquelle und strahlungserzeugende oberflächenemittierende Struktur sind bevorzugt auf einem gemeinsamen Substrat epitaktisch aufgewachsen. Das heißt, die Pumpstrahlquelle ist bevorzugt monolithisch in die Halbleiterlaser-Vorrichtung integriert. Die Schichtdicken der einzelnen Halbleiterschichten lassen sich bei der Epitaxie sehr genau einstellen, sodass vorteilhafterweise eine hohe Positionierungsgenauigkeit der kantenemittierenden Halbleiter-Struktur zur oberflächenemittierenden strahlungserzeugenden Struktur erreicht werden kann. Besonders bevorzugt sind die oberflächenemittierende Struktur und die Pumpstrahlquelle derart nebeneinander auf dem Substrat angeordnet, dass wenigstens eine aktive Zone der Pumpstrahlquelle, die zur Erzeugung von elektromagnetischer Strahlung geeignet ist, und die Quantentopfstruktur auf gleicher Höhe über dem Substrat liegen. Dadurch wird erreicht, dass im Betrieb der Halbleiterlaser-vorrichtung Pumpstrahlung seitlich in die Quantentopfstruktur eingekoppelt wird. Das bedeutet, dass die Emissionsrichtung der Pumpstrahlung im Wesentlichen parallel zur Substratoberfläche und im wesentlichen vertikal zur Emissionsrichtung des von der oberflächenemittierenden Halbleiterlaser-Struktur erzeugten Laserstrahls verläuft.

Das Intensitätsprofil der Pumpstrahlquelle quer zur Emissionsrichtung der Pumpstrahlquelle folgt bevorzugt einer vorgebbaren Kurve. Das heißt, es besteht die Möglichkeit, bei der Pumpstrahlquelle quer zur Emissionsrichtung, das heißt in lateraler Richtung, ein gewünschtes Intensitätsprofil einzustellen. Die oberflächenemittierende Halbleiterlaser-Vorrichtung enthält bevorzugt also wenigstens eine monolithisch integrierte Pumpstrahlquelle, bei der die Pumpstrahlquelle wenigstens eine kantenemittierende Halbleiter-Struktur aufweist, die zur Emission elektromagnetischer Strahlung geeignet ist, deren Intensitätsprofil quer zur Emissionsrichtung einer vorgebbaren Kurve folgt.

Die oberflächenemittierende strahlungserzeugende Struktur und die aktive Zone der Pumpstrahlquelle weisen bevorzugt unterschiedliche strahlungsemittierende Schichten auf, die so ausgebildet sind, dass die Wellenlänge der von der Pumpstrahlquelle emittierten Strahlung kleiner ist als die Wellenlänge der von der oberflächenemittierenden Struktur erzeugten Strahlung. Dieser Wellenlängenunterschied ist notwendig, da anderenfalls bei gleicher Pump- und Emissionswellenlänge die von der oberflächenemittierenden Struktur erzeugte Strahlung in gleicher Weise wie die Pumpstrahlung in der oberflächenemittierenden Struktur absorbiert würde. In der Folge würde die Effizienz der Halbleiterlaser-Vorrichtung stark abnehmen.

Die Halbleiterlaser-Vorrichtung macht sich die Idee zunutze, dass die räumliche Verteilung von Ladungsträgern in der oberflächenemittierenden Struktur, das so genannte Gain-Profil der oberflächenemittierenden Struktur insbesondere durch das Pumpprofil, mit dem die Struktur gepumpt wird, bestimmt ist. Das heißt, dass Profil der in der oberflächenemittierenden Struktur absorbierten Leistung bestimmt die räumliche Verteilung von Landungsträgern in der oberflächenemittierenden Struktur. Aufgrund dessen, dass das Intensitätsprofil der Pumpstrahlquelle quer zur Emissionsrichtung einer vorgebbaren Kurve folgt, lässt sich vorteilhafterweise ein gewünschtes Gain-Profil in der oberflächenemittierenden Struktur erzeugen. Dabei ist zudem vorteilhaft, dass das Strahlprofil des von der Halbleiterlaser-Vorrichtung emittierten Laserstrahls durch das Gain-Profil in der oberflächenemittierenden Struktur bestimmt ist. Das Gain-Profil bestimmt nämlich, welche Moden im oberflächenemittierenden Laser anschwingen können. Auf diese Weise ergibt sich zudem besonders vorteilhaft, dass über das Intensitätsprofil der Pumpstrahlquelle das Strahlprofil des oberflächenemittierenden Lasers eingestellt werden kann. Insbesondere kann durch eine geeignetes Pumpprofil gezielt eine gewünschte transversale Mode im oberflächenemittierenden Laser angesprochen werden, so dass der oberflächenemittierende Laser hauptsächlich in dieser Mode anschwingt.

Besonders vorteilhaft weist das Intensitätsprofil der Pumpstrahlquelle dabei wenigstens ein lokales Maximum auf. Da durch das Intensitätsprofil der Pumpstrahlquelle das Gain-Profil in der oberflächenemittierenden Struktur räumlich beeinflusst werden kann, bewirkt ein Maximum im Intensitätsprofil der Pumpstrahlquelle ein Maximum im Gain-Profil und damit im Strahlprofil des oberflächenemittierenden Lasers. Auf diese Weise lässt sich die Leistungsdichte des vom oberflächenemittierenden Laser erzeugten Strahls räumlich kontrollieren.

Bei einer bevorzugten Ausführungsform verläuft das Intensitätsprofil der Pumpstrahlquelle in lateraler Richtung nach Art einer Glockenkurve. Besonders bevorzugt folgt es ungefähr einer Gaußglockenkurve. Ungefähr heißt in diesem Zusammenhang, dass sich aufgrund der üblichen Schwankungen bei der Herstellung der Pumpstrahlquelle und im Betrieb der Pumpstrahlquelle, beispielsweise verursacht durch Temperaturschwankungen, kaum ein mathematisch exaktes Gaußprofil einstellen lässt. Auch kann sich, aufgrund der räumlichen Beschränkung der Pumpstrahlquelle, das Intensitätsprofil am Rand der Pumpstrahlquelle nicht asymptotisch einem konstanten Wert nähern, wie es bei einem mathematisch exakten Gaußprofil der Fall wäre. Vielmehr fällt das Intensitätsprofil am Rand der Pumpstrahlquelle plötzlich auf Null ab. Bevorzugt ist das Maximum des Intensitätsprofils in der Mitte oder in der Nähe der Mitte der Pumpstrahlquelle lokalisiert, wobei das Intensitätsprofil bevorzugt symmetrisch zu einer Mittelachse verläuft, die sich längs der Emissionsrichtung des Kanten-Emitters erstreckt. Dort wird das Intensitätsprofil besonders gut durch die Glockenkurve wiedergegeben.

Besonders vorteilhaft erweist sich solch ein gaußartiges Intensitätsprofil, da sich damit mit der Emission einer oder mehrerer Pumpstrahlquellen ein radialsymmetrisches Gain-Profil in der oberflächenemittierenden Struktur erzeugen lässt. Besonders bevorzugt ist dieses Gain-Profil gaußartig. Dadurch lässt sich nämlich vorteilhaft erreichen, dass im oberflächenemittierenden Laser vor allem die transversale Grundmode anschwingt.

Es ergibt sich vorteilhaft ein von der oberflächenemittierenden Struktur emittierter Laserstrahl mit einem gaußförmigen Strahlprofil von besonders hoher Strahlqualität. Das heißt, der Strahl weist ein radialsymmetrisches Strahlprofil auf und zeichnet sich durch einen $M^2$-Wert von annähernd 1 aus. Weiter zeichnet sich der Strahl durch eine besonders hohe Leistungsdichte aus. Aufgrund der Tatsache, dass durch die gaußförmige Pumpstrahlung gezielt die Grundmode angeregt wird, lässt sich der oberflächenemittierenden Laser auch mit hoher Leistung pumpen, ohne dass höhere transversale Moden nennenswert anschwingen. Das besonders vorteilhafte radialsymmetrische Strahlprofil des oberflächenemittierenden Lasers bleibt damit auch bei höheren Pumpraten erhalten.

Besonders vorteilhaft erweist sich dieses Strahlprofil beispielsweise bei der Materialverarbeitung. Hier kann z. B. an definierten, kleinen Flächen mit hoher Leistungsdichte lasergeschweißt werden. Auch für optische Darstellung, beispielsweise durch Laserprojektion, erweist sich die Strahlform als besonders vorteilhaft. Hier können besonders scharf abgegrenzte Punkte hoher Intensität erzeugt werden, wodurch die Darstellungen brillanter, hoch aufgelöster Bilder möglich wird. Auch für die Einkopplung des Laserstrahls in einen Lichtleiter erweist sich die radialsymmetrische Strahlform als besonders geeignet. Die hohe Leistungsdichte der beschriebenen Halbleiterlaser-Vorrichtung kann dafür sorgen, dass eine Strahlverstärkung während der Datenübertragung seltener notwendig ist. Damit wird die Herstellung besonders kostengünstiger Datenübertragungsstrecken möglich.

In einer bevorzugten Ausführungsform sind Mittel zur inhomogenen Bestromung bestimmter Bereiche der aktiven Zone der Pumpstrahlstruktur vorgesehen, wobei sich die Inhomogenität auf eine Richtung quer zur Emissionsrichtung der Halbleiter-Struktur bezieht. Das heißt, in einer Richtung quer zur Emissionsrichtung der Pumpstrahlquelle ist die Stromdichte in der aktiven Zone nicht konstant oder annähernd konstant, sondern es sind Mittel vorgesehen, die zu einer inhomogenen Verteilung der Stromdichte in lateraler Richtung in der aktiven Zone führen.

Dabei ist es nicht notwendig, dass die Bestromung quer zur Emissionsrichtung an jeder Stelle längs der Emissionsrichtung der Halbleiter-Struktur inhomogen ist, sondern es ist auch möglich, dass es homogen bestromte Teilbereiche in der aktiven Zone gibt. Das bedeutet, dass sich in diesen Bereichen quer zur Emissionsrichtung die Stromdichte in der aktiven Zone nicht oder im Wesentlichen nicht ändert.

Durch eine inhomogene Bestromung der aktiven Zone der Pumpstrahlquelle ergibt sich vorteilhaft eine inhomogene Ladungsträgerdichteverteilung in lateraler Richtung, quer zur Emissionsrichtung. Es kann also vorteilhaft mittels Gewinn-Führung ein gewünschtes Intensitätsprofil der erzeugten Strahlung quer zur Emissionsrichtung modelliert werden, das sich aus einer Überlagerung mehrerer transversale Moden zusammensetzt.

In einer weiteren Ausführungsform sind Mittel zur inhomogenen Bestromung der aktiven Zone derart vorgesehen, dass die Stromdichte in der aktiven Zone quer zur Emissionsrichtung, gemittelt über die Resonatorlänge der Halbleiter-Struktur, einer vorgebbaren Kurve folgt. Der Resonator der Halbleiter-Struktur erstreckt sich in Emissionsrichtung und ist beispielsweise durch reflektierende Flächen an den Enden der kantenemittierenden Halbleiter-Struktur, die senkrecht zur Emissionsrichtung verlaufen, begrenzt.

Der über die Resonatorlänge gemittelte Verlauf der Stromdichte in der aktiven Zone folgt im Wesentlichen einer vorgebbaren Kurve. Im wesentlichen einer vorgebbaren Kurve heißt, dass Schwankungen in der Materialzusammensetzung oder der Betriebstemperatur dazu führen, dass die Bestromung nicht exakt der vorgegebenen Kurve folgt, sondern bis zu einem bestimmten Grad von ihr abweicht. Vor allem an den Rändern der Halbleiter-Struktur kann es aufgrund der endlichen Ausdehnung der Pumpstrahlquelle zu Abweichungen von der gewünschten Kurve kommen. Der tatsächliche Verlauf der inhomogenen Bestromung wird jedoch vor allem in der Mitte der Halbleiter-Struktur durch die Kurve gut wiedergegeben.

Die beschriebene inhomogene Bestromung der aktiven Zone ist beispielsweise durch eine geeignete Strukturierung kontaktierter Flächen auf wenigstens einer Oberfläche der Pumpstrahlquelle möglich. Über die kontaktierten Flächen wird Strom in die aktive Zone eingeprägt. Die kontaktierten Flächen sind beispielsweise so auf der Oberfläche der Pumpstrahlquelle angeordnet, dass nur über bestimmte Bereiche der Oberfläche Strom in die aktive Zone eingeprägt wird. Die Inhomogenität der Anordnung und Ausdehnung der kontaktierten Flächen verursacht eine Inhomogenität der Stromdichte in der aktiven Zone. Dabei ist zu beachten, dass die Stromdichte in der aktiven Zone der Halbleiter-Struktur nicht identisch mit der Stromdichte an der Oberfläche der Pumpstrahlquelle sein muss. Der eingeprägte Strom kann vielmehr auf dem Weg von der Oberfläche zur aktiven Zone hin beispielsweise aufweiten. Eine solche Stromaufweitung kann jedoch durch entsprechend dimensionierte kontaktierte Flächen auf der Oberfläche berücksichtigt werden. So ist es beispielsweise möglich, die kontaktierten Flächen in solcher Weise zu wählen, dass durch die Aufweitung des Stroms auf seinem Weg von der Oberfläche zur aktiven Zone ein Bereich gewünschter Form und Größe in der aktiven Zone bestromt wird.

In einer weiteren Ausführungsform sind Mittel zur Bestromung der aktiven Zone der Halbleiter-Struktur vorgesehen, sodass die Stromdichte in der aktiven Zone quer zur Emissionsrichtung der Pumpstrahlquelle einer vorgebbaren Kurve folgt. In diesem Ausführungsbeispiel folgt die Stromdichte also an jeder Stelle längs der Emissionsrichtung der aktiven Zone in lateraler Richtung einer vorgebbaren Kurve. Es ist aber nicht notwendig, dass die Kurve genau den Verlauf der Stromdichte wiedergibt. Vor allem an den Rändern der aktiven Zone kann es wiederum zu Abweichungen vom vorgegebenen Verlauf kommen.

In einer weiteren bevorzugten Ausführungsform sind Mittel zur Bestromung der aktiven Zone derart vorgesehen, dass die Stromdichte quer zur Emissionsrichtung einer Kurve mit wenigstens einem Maximum folgt. Dabei ist es sowohl möglich, dass die Stromdichte gemittelt über die Resonatorlänge einer solchen Kurve folgt, als auch, dass die Stromdichte an jeder Stelle quer zur Emissionsrichtung dieser Kurve folgt. Bevorzugt verläuft die Stromdichte nach Art einer Glockenkurve, besonders bevorzugt verläuft die Stromdichte gaußglockenkurvenartig.

Die Ausgangsleistung des Kanten-Emitters hängt gemäß folgender Formel näherungsweise von der Stromdichte in lateraler Richtung (y), quer zur Emissionsrichtung ab:

$$p(y) = \eta \, (j(y) - j_{th}).$$

Dabei ist $\eta$ eine Konstante, die beispielsweise von den verwendeten Materialien oder der Geometrie der aktiven Zone abhängt, und $j_{th}$ ist eine Schwellenstromdichte des Kanten-Emitters. Wird nun ein Strom in die aktive Zone des Kantenemitters eingeprägt, sodass die Stromdichte näherungsweise

$$j(y) = j_{th} + C_0 \exp\!\left(-y^2 \Big/ w^2\right)$$

folgt, ergibt sich vorteilhaft ein Intensitätsprofil der emittierten Strahlung des Kanten-Emitters quer zur Emissionsrichtung, das einer Gaußglockenkurve folgt. $C_0$ ist dabei eine Konstante und w ist die Breite der Gaußkurve. Das Maximum der Gaußglocke liegt dabei bevorzugt innerhalb der aktiven Zone. Besonders bevorzugt befindet sich das Maximum in der Mitte der aktiven Zone, auf einer Mittelachse, die sich längs der Emissionsrichtung erstreckt. In lateraler Richtung ist der Verlauf der Stromdichte also bevorzugt symmetrisch zur Mittelachse.

Darüber hinaus ist es vorteilhaft möglich, dass durch geeignete Wahl des Verlaufs der Stromdichte in y-Richtung ein anderes gewünschtes Intensitätsprofil der Pumpstrahlquelle erzeugt wird. Damit lässt sich über die Wahl der Stromdichte im Pumplaser gezielt ein gewünschtes Strahlprofil in der oberflächenemittierenden Struktur erzeugen.

In einer weiteren bevorzugten Ausführungsform weist die kantenemittierende Halbleiter-Struktur auf wenigstens einer ihrer Oberflächen eine derart kontaktierte Fläche auf, dass bei einem Überfahren der Oberfläche quer zur Emissionsrichtung der Halbleiter-Struktur von außen zur Mitte hin der Anteil der kontaktierten Fläche an der Gesamtfläche der Oberfläche variiert. Der Anteil der kontaktierten Fläche kann beim Überfahren beispielsweise kontinuierlich zunehmen oder abnehmen. Es ist auch möglich, dass der Anteil der kontaktierten Fläche im Wechsel zu- und abnimmt. Wichtig ist, dass die Oberfläche nicht ganzflächig, homogen kontaktiert wird, sondern nur bestimmte, ausgesuchte Bereiche der Oberfläche kontaktiert sind. Über die kontaktierte Fläche wird Strom in die aktive Zone eingeprägt.

Bevorzugt ist die kontaktierte Fläche durch wenigstens zwei streifenartige kontaktierte Bereiche bestimmter Breite gegeben, d. h. die kontaktierte Fläche ist durch Streifen gegeben, über die Strom in die aktive Zone der Pumpstrahlquelle eingeprägt werden kann. Bevorzugt haben die Streifen eine bestimmte, vorgegebene Breite. Besonders bevorzugt befinden sich die Streifen in bestimmten, vorgegebenen Abständen zueinander. Die Streifen verlaufen beispielsweise längs der Emissionsrichtung der Halbleiter-Struktur. Sie erstrecken sich bevorzugt längs der gesamten Resonatorlänge des Kanten-Emitters. Besonders bevorzugt ist die kontaktierte Fläche durch eine Vielzahl von streifenartigen kontaktierten Bereichen gegeben.

In einer anderen Ausführungsform nimmt die Breite der kontaktierten Bereiche von einer Achse der Halbleiter-Struktur, die sich parallel zur Emissionsrichtung erstreckt, nach außen hin ab. Die Achse kann beispielsweise durch die Mitte der oberflächenemittierenden Halbleiter-Struktur verlaufen. Die Achse erstreckt sich bevorzugt durch die Mitte des breitesten Bereichs. Von der Achse nach außen zu den Rändern der Pumpstrahlquelle hin werden die kontaktierten Bereiche dann dünner.

In einer anderen Ausführungsform kann der Abstand der Bereiche von der Achse nach außen hin zunehmen. Die Breite der Bereiche kann dabei konstant bleiben oder abnehmen. Besonders bevorzugt folgt die Breite der Bereiche ungefähr einer Gaußverteilung. Dies ist besonders vorteilhaft, da auf diese Weise eine gaußartige Bestromung der aktiven Zone quer zur Emissionsrichtung und damit, wie oben dargelegt, eine gaußförmige Intensitätsverteilung erreicht werden kann. Die Breite der Streifen kann vorteilhaft so gewählt werden, dass ein Aufweiten des Stroms von den kontaktierten Bereichen zur aktiven Zone hin berücksichtigt wird. Das heißt, die Streifen werden etwas schmäler gewählt, als die gewünschte Breite des zu bestromenden Bereichs in der aktiven Zone.

In einer anderen Ausführungsform weist die kantenemittierende Halbleiterstruktur an wenigstens einer ihrer Oberflächen wenigstens zwei nicht kontaktierte Bereiche auf. Die nicht kontaktierten Bereiche sind dabei derart gestaltet, dass sich die Breite der nicht kontaktierten Bereiche vom Rand der Oberfläche zur Mittelachse hin verringert.

Im Folgenden wird die hier beschriebene oberflächenemittierende Halbleiterlaser-Vorrichtung anhand von Ausführungsbeispielen und den dazu gehörigen Figuren näher erläutert.

Figur 1 zeigt eine schematische Darstellung eines Schnitts durch ein erstes Ausführungsbeispiel der oberflächenemittierenden Halbleiterlaser-Vorrichtung.

Figur 2 zeigt eine schematische Darstellung eines Schnitts durch ein zweites Ausführungsbeispiel der oberflächenemittierenden Halbleiterlaser-Vorrichtung.

Figur 3 zeigt eine schematische Darstellung einer Draufsicht auf eine Halbleiterlaser-Vorrichtung mit einer kantenemittierenden Halbleiter-Struktur nach dem Stand der Technik.

Figur 4 zeigt eine schematische Darstellung einer Draufsicht auf eine Halbleiterlaser-Vorrichtung mit streifenartig kontaktierten Bereichen.

Figur 5 zeigt eine schematische Darstellung einer Draufsicht auf eine Halbleiterlaser-Vorrichtung mit über die Resonatorlänge gemittelten kontaktierten Bereichen.

Figur 6 zeigt eine schematische Darstellung einer Draufsicht einer Halbleiterlaser-Vorrichtung nach einem zweiten Ausführungsbeispiel.

Figur 7 zeigt eine schematische Darstellung einer Draufsicht auf eine Halbleiterlaser-Vorrichtung nach einem dritten Ausführungsbeispiel.

Figur 8 zeigt eine schematische Darstellung einer Draufsicht auf eine Halbleiterlaser-Vorrichtung nach einem vierten Ausführungsbeispiel.

Figur 9 zeigt ein Absorptionsprofil einer oberflächenemittierenden Struktur, die mit einer Pumpstrahlquelle nach dem Stand der Technik gepumpt ist.

Figur 10 zeigt ein Absorptionsprofil einer oberflächenemittierenden Struktur, die mit einer Pumpstrahlquelle gemäß eines der Ausführungsbeispiele der beschriebenen Halbleiterlaser-Vorrichtung gepumpt ist.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

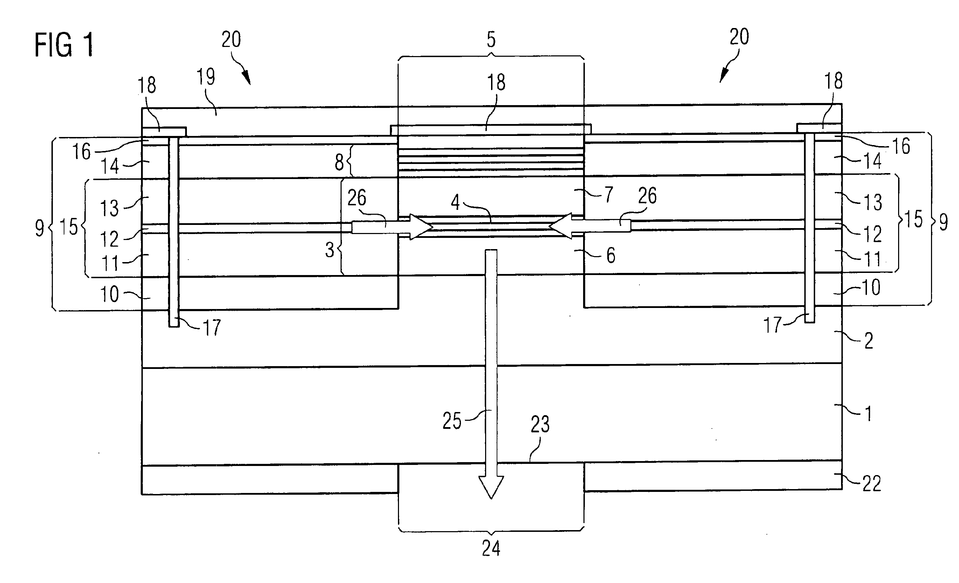

Figur 1 zeigt eine schematische Schnittdarstellung eines Ausführungsbeispiels der beschriebenen oberflächenemittierenden Halbleiterlaser-Vorrichtung.

Bei dieser ist auf ein Substrat 1 eine Pufferschicht 2 aufgebracht. Auf die Pufferschicht 2 ist mittig über dem Substrat eine oberflächenemittierende Halbleiterlaser-Struktur 3 mit beispielsweise einer strahlungserzeugenden Quantentopfstruktur 4 aufgebracht, die den oberflächenemittierenden Laserbereich 5 darstellt. Die Halbleiterlaser-Struktur 3 setzt sich zusammen aus einer unmittelbar auf der Pufferschicht 2 befindlichen ersten n-dotierten Mantelschicht 6 und einer auf der Quantentopfstruktur 4 angeordneten p-dotierten Mantelschicht 7. Die Quantentopfstruktur 4 weist beispielsweise eine Vielzahl von Quantentöpfen auf.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Über der oberflächenemittierenden Halbleiterlaser-Struktur 3 ist beispielsweise ein Bragg-Spiegel 8 abgeschieden.

In der Umgebung des oberflächenemittierenden Laserbereiches 5 ist beispielsweise auf der Pufferschicht 2 eine kantenemittierende Halbleiterlaser-Struktur 9 abgeschieden, die geeignet ist, Strahlung zu erzeugen, deren Wellenlänge unterhalb der Wellenlänge der in der oberflächenemittierenden Halbleiterlaser-Struktur 3 erzeugten Strahlung liegt. Die kantenemittierende Halbleiter-Struktur 9 kann sich z. B. aus einer ersten n-dotierten Mantelschicht 10, einer ersten n-dotierten Wellenleiterschicht 11, einer aktiven Zone 12, einer p-dotierten zweiten Wellenleiterschicht 13 und einer p-dotierten zweiten Mantelschicht 14 zusammensetzen. Die aktive Zone 12 enthält eine strahlungserzeugende Struktur, beispielsweise eine Quantentopfstruktur mit einem oder mehreren Quantentöpfen. Auf der zweiten Mantelschicht 14 ist beispielsweise eine p-dotierte Deckschicht 16 angeordnet.

Der strahlungsemittierende Bereich 15 ist in etwa höhengleich mit der strahlungserzeugenden oberflächenemittierenden Struktur 4 angeordnet, vorzugsweise befinden sich die aktive Zone 12 und die Quantentopfstruktur 4 in gleicher Höhe über dem Substrat 1.

Sämtliche Halbleiter-Schichten sind beispielsweise mittels metallorganischer Dampfphasenepitaxie (MOVPE) hergestellt und können beispielsweise auf ein Substrat 1, das Galliumarsenid enthält, in einem der folgenden Materialsysteme gebildet sein: InGaAlAs, InAlGaN, InGaAsP InGaAlP.

In der Nähe des äußeren Randes der kantenemittierenden Halbleiter-Struktur 9 befinden sich senkrecht zu den Schichten der kantenemittierenden Halbleiter-Struktur 9 verlaufende Endspiegel 17. Diese sind beispielsweise nach dem Aufwachsen der kantenemittierenden Halbleiter-Struktur 9 mittels Ätzen von entsprechenden Gräben und dem nachfolgenden Füllen mit hoch reflektierendem Material hergestellt. Alternativ können die Endspiegel 17 durch Spalten des Wafers entlang von Kristallebenen hergestellt werden. Diese sind dann notwendigerweise nicht, wie in Figur 1 dargestellt, im Chip angeordnet, sondern durch die gespaltene Chipseitenfläche gebildet.

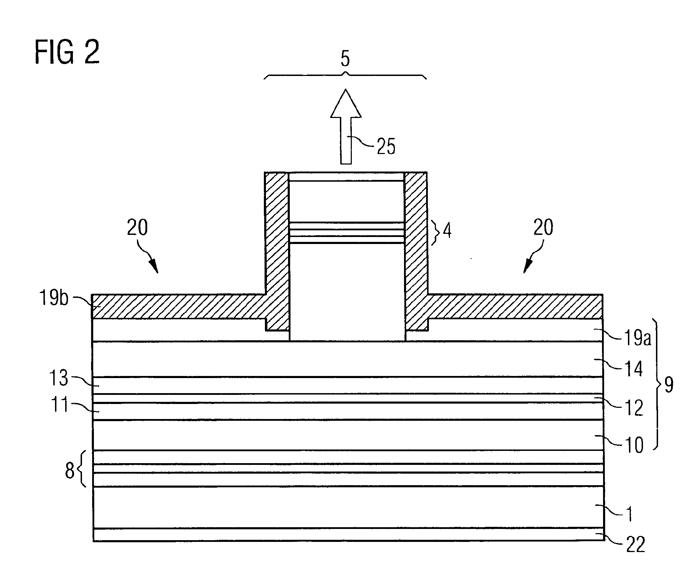

Auf den freien Oberflächen der Deckschicht 16 und des Bragg-Spiegels 8 befindet sich eine elektrisch isolierende Maskenschicht 18, die beispielsweise Siliziumnitrid, Aluminiumoxid oder Siliziumoxid enthält und die kontaktierten Bereiche 31 definiert (vergleiche Figuren 2 bis 4). Auf der Maskenschicht 18 und deren Aussparungen auf der Deckschicht 16 ist eine p-Kontaktschicht 19, z. B. eine Kontaktmetallisierung, aufgebracht, durch die die Pumpstrahlquelle 20 p-seitig elektrisch kontaktiert werden kann. Das heißt, dort wo die Maskenschicht 18 Aussparungen aufweist, kontaktiert die p-Kontaktschicht 19 die Deckschicht 16 und definiert auf diese Weise die kontaktierten Bereiche 31.

Auf der Unterseite des Substrats 1 ist eine n-Kontaktschicht 22 aufgebracht.

Die von der Halbleiter-Struktur abgewandte Hauptfläche 23 des Substrats 1 ist dabei in einem Austrittsfenster 24 für den Laserstrahl (angedeutet durch den Pfeil 25) von der n-Kontaktschicht 22 unbedeckt.

Ein Laserresonator der oberflächenemittierenden Struktur 3 kann aus dem Bragg-Spiegel 8 und einem auf der gegenüberliegenden Seite des Substrats 1 angeordneten weiteren Spiegel (nicht dargestellt) oder einen zwischen Substrat 1 und Quantentopf-Struktur 4 angeordneten weiteren Bragg-Spiegel gebildet sein.

Im Betrieb der Halbleiterlaser-Vorrichtung wird durch die kontaktierten Bereiche 31 der kantenemittierenden Halbleiter-Struktur 9, die die Pumpstrahlquelle 20 darstellt, Pumpstrahlung (angedeutet durch die Pfeile 26) erzeugt, von der ein Teil in die Quantentopfstruktur 4 eingekoppelt wird. Bevorzugt wird in der Pumpstrahlquelle 20 Laserstrahlung erzeugt, was zu einer Erhöhung der Pumpeffizienz führt. Besonders bevorzugt folgt die Intensitätsverteilung der Pumpstrahlung quer zu Emissionsrichtung in lateraler Richtung einer vorgebbaren Kurve.

Vorzugsweise sind die Endspiegel 17 derart zueinander angeordnet, dass diese einen Laserresonator für zwei einander gegenüberliegende strahlungsemittierende Bereiche der kantenemittierenden Struktur 9 ausbilden. Die zwei gegenüberliegenden strahlungsemittierenden Bereiche der kantenemittierenden Struktur 9 sind dann nach dem Transparentpumpen der oberflächenemittierenden Laserstruktur 3 zu einem einzigen kohärent schwingenden Laser verkoppelt.

Figur 2 zeigt eine schematische Darstellung eines Schnitts durch ein zweites Ausführungsbeispiel der oberflächenemittierenden Halbleitervorrichtung.

Es ist hier ein in Einschrittepitaxie gewachsener Scheibenlaser gezeigt, bei dem die Pumpstrahlung nach oben in die Quantentopfstruktur 4 des oberflächenemittierenden Lasers 5, die beispielsweise eine Vielzahl von Quantentöpfen enthält, eingekoppelt wird. Die Einkopplung in die Quantentopstruktur 4 erfolgt dabei beispielsweise aufgrund von Sprüngen im Brechungsindex der Wellenleiterschichten 11, 13.

Der Pumplaser 20 ist durch beispielsweise optisch gekoppelte Kantenemitter 9 gegeben. Die Laserfacetten des Pumplasers 20 sind bevorzugt durch Ritzen und Brechen entlag der kristallographischen Achsen des Halbleitersubstrats 1 und anschließendes Verspiegeln mit hoher Reflektivität (R>90%) hergestellt. Dadurch wird höchstens ein kleiner Anteil der Pumpstrahlung aus dem lateralen Resonator ausgekoppelt. Über den resonatorinternen oberflächenemittierenden Laser 5 ist durch die Absorption der Pumpstrahlung 26 in der Quantentopstruktur ein effizienter optischer Pumpmechanismus realisiert.

Der Vorteil dieses Ausführungsbeispiels liegt dabei in der fertigungstechnisch besonders einfachen Ausführungsform. Nach der Epitaxie ist im Bereich des Pumplasers 20 durch selektives Ätzen mittels Ätzstoppschicht definiert in den Wellenleiter geätzt und anschließend ein transparenter leitfähiger p-Kontakt 19a, der beispielsweise ZnO enthalten kann, und eine p-Kontaktmetallisierung 19b aufgebracht, die vorzugsweise auch als metallischer Reflektor für das Pumplicht dient. Die p-Kontaktmetallisierung 19a, 19b ist vorzugsweise im Bereich des Kantenemitters 9 derart strukturiert, dass kontaktierte Bereiche 31 definiert werden. Dies kann beispielsweise wiederum mittels einer Maskenschicht realisiert sein.

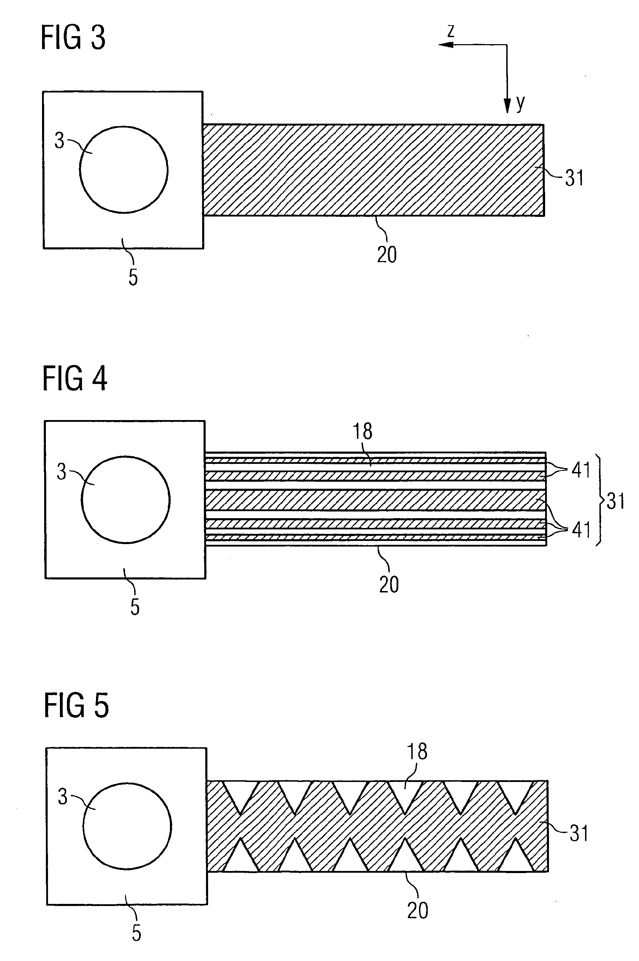

Figur 3 zeigt eine schematische Darstellung einer Draufsicht auf eine Halbleiterlaser-Vorrichtung, umfassend einen oberflächenemittierenden Laserbereich 5 mit einer oberflächenemittierenden Halbleiter-Struktur 3 und einer Pumpstrahlquelle 20 mit einer kontaktierten Fläche 31 nach dem Stand der Technik. Hier ist die Pumpstrahlquelle 20 durch beispielsweise einen großflächig kontaktierten Breitstreifenlaser gebildet. Dadurch, dass die Pumpstrahlquelle 20 p-seitig mit einer homogen kontaktierten Fläche 31 bedeckt ist, die die Oberseite der Pumpstrahlquelle vollständig oder annähernd vollständig bedeckt, wird die aktive Zone 12 des Kanten-Emitters 15 homogen bestromt. Diese homogene Bestromung der aktiven Zone 12 führt dazu, dass die Laseremission der Pumpstrahlquelle 20 in lateraler Richtung (die laterale Richtung ist in Figur 3 durch den Pfeil y angedeutet) eine Überlagerung vieler Moden darstellt, deren Summe ein annähernd rechteckiges Intensitätsprofil in y-Richtung bildet.

Für den Vertikal-Emitter 5 gilt nun, dass das Abstrahlleistungsprofil näherungsweise durch

$$P = \eta_{vertikal}(P_{abs} - P_{th,vertikal})$$

gegeben ist. Dabei bezeichnet $\eta_{vertikal}$ eine Proportionalitätskonstante für den Vertikal-Emitter 5, $P_{abs}$ ist das Absorptionsprofil der von der oberflächenemittierenden Struktur 4 absorbierten Leistung und $P_{th,vertikal}$ ist eine Schwellenleistung, die angibt, ab welcher Pumpleistung die Lasererzeugung einsetzt. Das heißt, die Abstrahlleistung des Vertikal-Emitters 5 wird im Wesentlichen durch sein Absorptionsprofil bestimmt. Dies bezieht sich sowohl auf die räumliche Verteilung als auch auf die Höhe der absorbierten Leistung. Das Absorptionsprofil gibt wiederum das Gain-Profil, d.h. die räumliche Verteilung von Landungsträgern in der oberflächenemittierenden Struktur 3 wider.

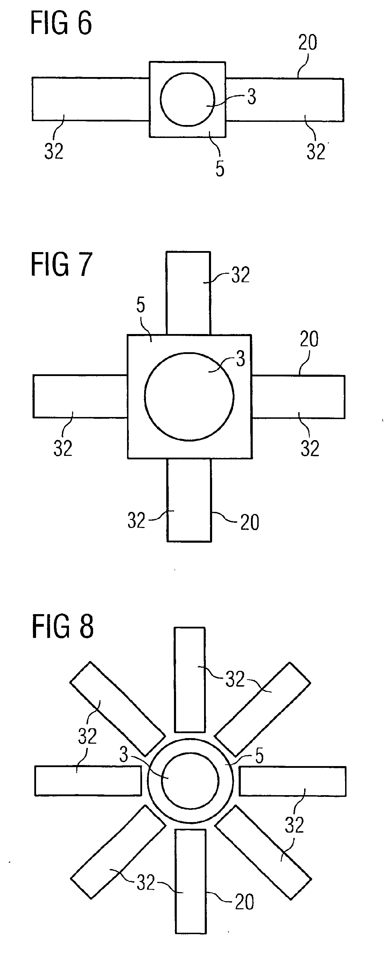

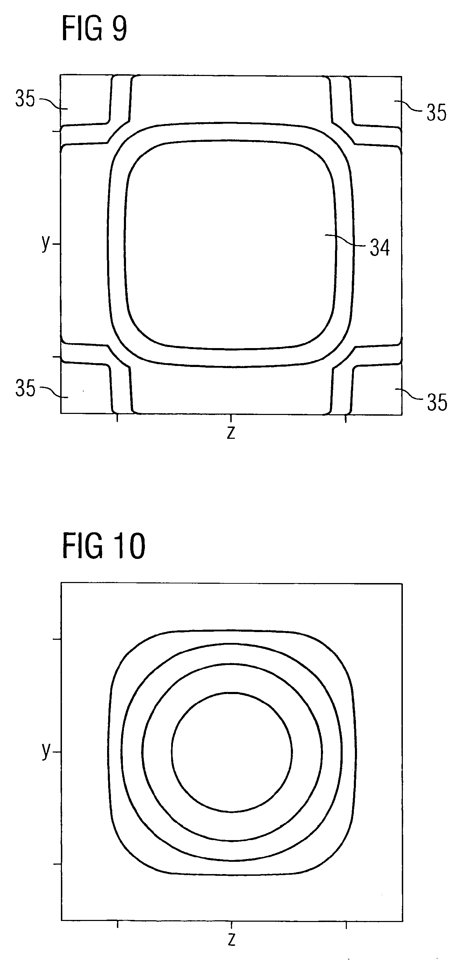

Eine Kontaktierung 31 der Pumpstrahlquelle 20 nach Figur 3 führt also zu einem annähernd rechteckigem Intensitätsprofil der emittierten Pumpstrahlung 26. Dies wiederum führt zu einem Absorptionsprofil im Vertikal-Emitter 5 nach Figur 9. Die Pumpstrahlquellen 20 können dabei wie beispielsweise in Figur 7 gezeigt auch senkrecht zueinander angeordnet sein.

Figur 9 zeigt ein Absorptionsprofil $P_{abs}$ einer oberflächenemittierenden Struktur 3. Aus Figur 9 ist ersichtlich, dass aufgrund des rechteckigen Pumpprofils auch das Absorptionsprofil rechteckig ist. Bedingt dadurch schwingen viele verschiedene transversale Moden im Vertikal-Emitter 5 an, deren Überlagerung ein eher rechteckiges Abstrahlleistungsprofil erzeugt. Die räumliche Verteilung der absorbierten Leistung ist dabei durch Höhenlinien dargestellt. In der Mitte 34 der oberflächenemittierenden Struktur 3 ist die absorbierte Leistung am größten. Jedoch gibt es auch an den Ränder 35 der oberflächenemittierenden Struktur 3 Bereiche in denen relativ viel Leistung absorbiert wird.

Da das Absorptionsprofil das Strahlprofil des Vertikal-Emitters 5 bestimmt, führt das vorliegende Absorptionsprofil zu einem eher rechteckigen Strahlprofil mit relativ geringer Leistungsdichte. Die Abstrahlleistung des Vertikal-Emitters verteilt sich auf eine relativ große Fläche. Wird der Vertikal-Emitter mit höherer Leistung gepumpt, wird nicht nur in die Grundmode, sondern auch in höhere transversale Moden gepumpt.

Figur 4 zeigt eine schematische Darstellung einer Draufsicht auf eine Halbleiterlaser-Vorrichtung mit einer kantenemittierenden Pumpstrahlquelle 20, deren kontaktierte Fläche 31 als streifenartige Bereiche 41 ausgebildet ist.

Die Streifen 41 erstrecken sich dabei in Richtung der Emissionsrichtung der Pumpstrahlquelle 20. Zwischen den kontaktierten Flächen 31 der Streifen 41 befinden sich nicht kontaktierte Flächen, die beispielsweise durch die entsprechend strukturierte isolierende Maskenschicht 18 definiert sind. Bei einem Überfahren der Oberfläche der Pumpstrahlquelle 20 von außen zur Mitte hin, nimmt der Anteil der kontaktierten Fläche 31 an der Gesamtfläche der Oberseite 32 der Pumpstrahlquelle 20 abwechselnd zu und ab. Aufgrund der Strukturierung der kontaktierten Fläche 31 in lateraler Richtung wird auch die aktive Zone 12 der Pumpstrahlquelle 20 in lateraler Richtung nicht homogen bestromt. Im vorliegenden Ausführungsbeispiel wird durch breitere Streifen 41 in der Mitte und schmalere Streifen 41 an den Rändern der Pumpstrahlquelle in die Mitte der aktiven Zone 12 mehr Strom eingeprägt als in ihre Ränder. Zahl, Breite und Abstand der kontaktierten Streifen 41 kann dem gewünschten Bestromungsprofil in der aktiven Zone 12 angepasst werden. Vorteilhaft lässt sich also über die Wahl der Streifenbreite und den Abstand der Streifen 41 ein gewünschtes Profil der Stromdichte in lateraler Richtung in der aktiven Zone 12 erzeugen. Durch Gewinn-Führung führt der Verlauf der Stromdichte in der aktiven Zone 12 zu einem gewünschten Intensitätsprofil der emittierten Pumpstrahlung 26 in lateraler Richtung.

Als besonders vorteilhaft erweist sich, wenn die Streifen 41 in ihrer Breite und Verteilung einer Gauß-Verteilung folgen, mit einem Maximum der Streifenbreite ungefähr in der Mitte der Pumpstrahlquelle. Durch diese Streifengeometrie wird in die aktive Zone 12 der Pumpstrahlquelle 20 ein Stromprofil eingeprägt, das in y-Richtung in etwa einer Gauß-Verteilung folgt. Die Moden im Kanten-Emitter überlagern sich dann auf eine solche Weise, dass die Pumpstrahlquelle Strahlung mit einem gaußförmigen Intensitätsprofil in lateraler Richtung emittiert. Als Absorptionsprofil ergibt sich dann im Vertikal-Emitter 5 ein in etwa gaußförmiger Verlauf.

Figur 10 zeigt, dass in diesem Fall im Vertikal-Emitter 5 das Absorptionsprofil radialsymmetrisch und im Wesentlichen gaußförmig ist. Vor allem die radialsymmetrische transversale Grundmode schwingt daher an. Durch die gaußförmige Intensitätsverteilung der Pumpstrahlung wird also gezielt in diese Mode gepumpt. Besonders vorteilhaft ist dabei, dass auch bei einer Erhöhung der Pumpleistung der Pumpstrahlquelle 20 nur in die Grundmode gepumpt wird und daher höhere Moden kaum oder gar nicht anschwingen. Das radialsymmetrische Absorptionsprofil des Vertikal-Emitters bleibt also auch bei höherer Pumpleistung erhalten. Auf diese Weise lässt sich mit dem Vertikal-Emitter ein Laserstrahl besonders guter Strahlqualität erzeugen. Dieser Laserstrahl weist ein radialsymmetrisches Strahlprofil mit einer hohen Leistungsdichte auf.

Figur 5 zeigt ein weiteres Ausführungsbeispiel der Halbleiterlaser-Vorrichtung. Die Pumpstrahlquelle weist hier eine kontaktierte Fläche in der Weise auf, dass gemittelt über die Resonatorlänge der Pumpstrahlquelle 20 ein Strom in die aktive Zone 12 eingeprägt wird, sodass sich beispielsweise in lateraler Richtung eine gaußförmige Stromdichte ergibt. Wie Figur 5 zeigt, befindet sich, über die Länge des Resonators gemittelt, in der Mitte der Oberseite der Pumpstrahlquelle mehr kontaktierte Fläche als an deren Rändern. Der Anteil der kontaktierten Fläche an der Gesamtfläche nimmt also bei einem Überfahren der Oberfläche quer zur Emissionsrichtung, also in y-Richtung, von außen zur Mitte hin zu. Dies wird beispielsweise dadurch erreicht, dass wie in Figur 5 gezeigt, mehrere nicht kontaktierte Bereiche auf der Oberfläche des Kantenemitters angeordnet sind. Die Breite der nicht kontaktierten Bereiche nimmt vom Rand zur Mitte der Oberfläche hin jeweils ab.

Neben den Ausführungsbeispielen der Figuren 4 und 5 sind zahlreiche weitere Strukturierungen der kontaktierten Fläche denkbar. Abhängig von der gewählten Strukturierung der kontaktierten Fläche kann eine bestimmte Stromdichte in die aktive Zone 12 eingeprägt werden, was wiederum zu einer vorgegebenen Intensitätsverteilung der von der kantenemittierenden Halbleiter-Struktur 9 emittierten Strahlung führt. So können beispielsweise Intensitätsprofile mit zwei oder mehreren lokalen Maxima erzeugt werden. Auf diese Weise ist es möglich, gezielt bestimmte höhere transversale Moden des Vertikal-Emitters 5 zu pumpen. So lassen sich Strahlprofile des Vertikal-Emitters 5 erzeugen, die mehrere lokale Maxima aufweisen.

Die Figuren 6, 7, und 8 zeigen verschiedene Möglichkeiten der Anordnung der Pumpstrahlquellen 20 um den Vertikal-Emitter 5. Dabei weisen die Pumpstrahlquellen 20 Oberseiten 32 mit den beispielsweise in den Figuren 4 und 5 beschriebenen strukturierten kontaktierten Flächen 31 auf. Durch Anzahl und Anordnung der Pumpstrahlquellen 20 bietet sich durch Überlagerung der Strahlung aus den einzelnen Pumpstrahlquellen eine zusätzliche Möglichkeit, das Absorptionsprofil im Vertikal-Emitter 5 einzustellen.

Diese Patentanmeldung beansprucht die Prioritäten der deutschen Patentanmeldungen 102004026115.6-11 und 102004036963.1-54, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

**Patentansprüche**

1. Oberflächenemittierende Halbleiter-Laservorrichtung,
   mit mindestens einer monolithisch integrierten Pumpstrahlquelle (20), bei der die Pumpstrahlquelle (20) wenigstens eine kantenemittierende Halbleiterstruktur (9) aufweist, die zur Emission elektromagnetischer Strahlung geeignet ist, deren Intensitätsprofil quer zur Emissionsrichtung (z) der Halbleiterstruktur einer vorgebaren Kurve folgt.

2. Oberflächenemittierende Halbleiter-Laservorrichtung nach Anspruch 1,
   bei der das Intensitätsprofil wenigstens ein lokales Maximum aufweist.

**3.** Oberflächenemittierende Halbleiter-Laservorrichtung nach Anspruch 1 oder 2, bei der das Intensitätsprofil nach Art einer Glockenkurve verläuft.

**4.** Oberflächenemittierende Halbleiter-Laservorrichtung nach einem der Ansprüche 1 bis 3, bei der Mittel zur inhomogenen Bestromung bestimmter Bereiche einer aktiven Zone (12) der Halbleiterstruktur (9) vorgesehen sind, wobei sich die Inhomogenität auf eine Richtung quer zur Emissionsrichtung (z) der Halbleiterstruktur bezieht.

**5.** Oberflächenemittierende Halbleiter-Laservorrichtung nach Anspruch 4, bei der Mittel zur Bestromung derart vorgesehen sind, dass die Stromdichte in der aktiven Zone quer zur Emissionsrichtung (z) gemittelt über die Resonatorlänge der Halbleiterstruktur (9) einer vorgebbaren Kurve folgt.

**6.** Oberflächenemittierende Halbleiter-Laservorrichtung nach Anspruch 4 oder 5, bei der Mittel zur Bestromung derart vorgesehen sind, dass die Stromdichte in der aktiven Zone (12) quer zur Emissionsrichtung einer vorgebbaren Kurve folgt.

**7.** Oberflächenemittierende Halbleiter-Laservorrichtung nach Anspruch 6, bei der Mittel zur Bestromung derart vorgesehen sind, dass die Stromdichte in der aktiven Zone (12) quer zur Emissionsrichtung (z) einer Kurve mit wenigstens einem lokalem Maximum folgt.

**8.** Oberflächenemittierende Halbleiter-Laservorrichtung nach Anspruch 6 oder 7, bei der die Stromdichte in der aktiven Zone quer zur Emissionsrichtung (z) nach Art einer Glockenkurve verläuft.

**9.** Oberflächenemittierende Halbleiter-Laservorrichtung nach einem der Ansprüche 1 bis 8, bei der die kantenemittierende Halbleiterstruktur (9) an wenigstens einer ihrer Oberflächen (32) eine derart kontaktierte Fläche (31) aufweist, dass bei einem Überfahren der Oberfläche (31) quer zu einer Emissionsrichtung (z) der Halbleiterstruktur von außen zur Mitte hin der Anteil der kontaktierten Fläche (31) an der Gesamtfläche variiert.

**10.** Oberflächenemittierende Halbleiter-Laservorrichtung nach Anspruch 9, bei der die kontaktierte Fläche (31) durch wenigstens zwei streifenartige kontaktierte Bereiche (41) bestimmter Breiten gegeben ist, die sich in bestimmten Abständen zueinander befinden und sich längs der Emissionsrichtung (z) erstrecken.

**11.** Oberflächenemittierende Halbleiter-Laservorrichtung nach Anspruch 10, bei der die Breite der Bereiche (41) von einer Achse der Halbleiterstruktur parallel zur Emissionsrichtung (z) aus nach außen hin abnimmt.

**12.** Oberflächenemittierende Halbleiter-Laservorrichtung nach Anspruch 10 oder 11, bei der der Abstand der Bereiche (41) von der Achse aus nach außen hin zunimmt.

**13.** Oberflächenemittierende Halbleiter-Laservorrichtung nach einem der Ansprüche 10 bis 12, bei der die Breite der Bereiche (41) von der Achse aus nach außen hin abnimmt und der Abstand der Bereiche (41) von der Mittelachse aus nach außen hin zunimmt.

**14.** Oberflächenemittierende Halbleiter-Laservorrichtung nach Anspruch 9, bei der die kantenemittierende Halbleiterstruktur (9) an wenigstens einer ihrer Oberflächen wenigstens zwei nicht kontaktierte Bereiche (18) aufweist, derart dass sich die Breite der nicht kontaktierten Bereiche (18) vom Rand der Oberfläche zur Mittelachse hin verringert.

FIG 1

FIG 2

FIG 3

FIG 4

FIG 5

FIG 6

FIG 7

FIG 8

FIG 9

FIG 10